# EUROPÄISCHE PATENTSCHRIFT

(11) **EP 1 532 696 B1**
(45) Veröffentlichungstag und Bekanntmachung des Hinweises auf die Patenterteilung: **09.05.2007**
(21) Anmeldenummer: 04766164.0
(22) Anmeldetag: 08.07.2004
(51) Int. Cl.: H01L 41/24

(54) **VERFAHREN ZUR HERSTELLUNG PIEZOKERAMISCHER MULTILAYER-SCHICHTEN UND PIEZO-ELEKTRISCHES BAUTEIL**
METHOD FOR PRODUCING PIEZOCERAMIC MULTI-LAYER LAMINATIONS AND A PIEZOELECTRIC COMPONENT
PROCEDE POUR PRODUIRE DES STRUCTURES MULTICOUCHES PIEZOCERAMIQUES ET COMPOSANT PIEZOELECTRIQUE

(30) Priorität: 10.07.2003 DE 10331318
(43) Veröffentlichungstag der Anmeldung: 25.05.2005
(73) Patentinhaber: SIEMENS AKTIENGESELLSCHAFT, 80333 München (DE)
(72) Erfinder: DÖLLGAST, Bernhard, 91054 Erlangen (DE)
(86) Internationale Anmeldenummer: PCT/EP2004/051418
(87) Internationale Veröffentlichungsnummer: WO 2005/006457

(56) Entgegenhaltungen:
- DE-A- 19 756 182
- US-A- 5 191 687
- US-A- 5 758 397
- US-A- 5 923 352
- PATENT ABSTRACTS OF JAPAN Bd. 1997, Nr. 01, 31. Januar 1997 (1997-01-31) -& JP 08 236833 A (TOKIN CORP), 13. September 1996 (1996-09-13)
- PATENT ABSTRACTS OF JAPAN Bd. 1998, Nr. 11, 30. September 1998 (1998-09-30) -& JP 10 163543 A (TDK CORP), 19. Juni 1998 (1998-06-19)

## Beschreibung

Die Erfindung betrifft ein Verfahren zur Herstellung eines piezo-elektrischen Bauteils, insbesondere eines Piezoaktors, und einen Injektor mit diesem Bauteil.

Beim Einsatz derartiger piezo-elektrischer Bauteile, die insbesondere aus Piezokeramiken hergestellt sind, wird der Effekt genutzt, dass diese beim Anlegen eines mechanischen Drucks eine Spannung erzeugen oder umgekehrt, beim Anlegen einer elektrischen Spannung an den Piezoaktor eine Ausdehnung des Aktors erreicht werden kann. Um die nutzbare Ausdehnungslänge zu vergrößern, werden monolithische Vielschichtaktoren verwendet, die aus einem gesinterten Stapel dünner Folien aus Piezokeramik mit eingelagerten Innenelektroden bestehen. Die Innenelektroden sind wechselseitig aus dem Stapel herausgeführt und über Außenelektroden elektrisch parallel geschaltet. Bevorzugt wird auf beiden Kontaktseiten des Stapels jeweils eine streifen- oder bandförmige durchgehende Außenmetallisierung aufgebracht. Die Außenmetallisierung ist mit allen Innenelektroden gleicher Polarität verbunden. Zwischen der Außenmetallisierung und den elektrischen Anschlüssen wird häufig noch eine in vielen Formen ausführbare Weiterkontaktierung vorgesehen. Legt man nun eine elektrische Spannung an die Außenmetallisierung an, so dehnt sich die Piezofolie in Richtung des angelegten Feldes. Durch die mechanische Serienschaltung der einzelnen Piezofolien wird die sogenannte Nenndehnung des gesamten Stapels schon bei relativ niedrigen Spannungen erreicht.

Wie aus der DE 199 30 585 A1 bekannt ist, können derartige Piezoaktoren beispielsweise zur Ansteuerung eines Einspritzventils in Brennkraftmaschinen eingesetzt werden.

Durch die Polarisation eines piezo-keramischen Stapels werden dessen Eigenschaften entscheidend bestimmt. Bei der Polarisation des Stapels, der als Multilayer hergestellt wird, entstehen an den Stellen, an denen die Elektroden in inaktive Schichten übergehen, Zugspannungen, die häufig zu Polungsrissen führen. Zur Polarisation des Stapels wird an die Elektroden ein elektrisches Polarisationsfeld angelegt, wodurch sich eine maximale permanente Polarisation und eine geordnete Verteilung der in Feldrichtung in dem Gefüge bzw. dem Kristall der Keramik ausgerichteten Domänen gegenüber dem unpolarisierten Ausgangszustand ergibt. Nach der Polarisation ist das Bauelement bleibend in der Richtung des angelegten Felds bzw. der remanenten Polarisation verlängert. Diese bleibende Verlängerung hat zur Folge, dass im inaktiven und nicht durch Feldeinwirkung verlängerten Kontaktbereich Zugspannungen auftreten. Dadurch können im piezo-elektrisch inaktiven Kontaktierungsbereich bei der Polarisation des Stapels Risse auftreten, die in der Ebene der Elektroden verlaufen. Diese kommen zwar im Übergangsbereich vom inaktiven zum aktiven Bereich des Bauelements zum Stillstand, können aber im späteren Betrieb des Bauelements zu Folgeschäden, bis hin zum Ausfall des Bauelements führen. Daher ist es nötig, das Auftreten von Rissen in der Keramik zu vermeiden, um die Lebensdauer der Bauelemente zu verlängern.

Um dies zu gewährleisten wurde in der DE 197 56 182 C2 bereits vorgeschlagen, den Stapel unter Druckspannung zu polarisieren. Hierzu wird der Stapel mit einer Druckspannung beaufschlagt, die größer als Null ist. Dann wird an den Stapel ein elektrisches Polarisationsfeld angelegt, wobei die elektrische Feldstärke größer ist als die Koerzitiv-Feldstärke für den Stapel. So kann der Stapel polarisiert werden. Wird die Druckspannung allerdings entfernt, so können erneut Risse auftreten. Daher wird dieses Verfahren vorzugsweise an den bereits mit einer Feder vorgespannten Stapeln durchgeführt. Werden bei der anschließenden Charakterisierung Fehler festgestellt, so muss die gesamte Einheit ausgetauscht werden, da sie unbrauchbar ist.

Aus der EP 350 941 A2 ist ein Verfahren zum Polarisieren eines Stapels bei erhöhter Temperatur bekannt. Hierzu wird der Stapel bei einer Temperatur von 20 - 70 °C über dem Curie-Punkt der Keramik einer elektrischen Spannung ausgesetzt. Bei einer Temperatur über dem Curie-Punkt liegt die Keramik in kubischer Kristallform vor. Unterhalb dieser Temperatur allerdings wandelt sich diese Phase in eine teilweise desorientierte Phase, die zumindest lokal Orientierungen aufweist. Wird nun ein definiertes elektrisches Feld oberhalb des Curie-Punkts in einer vorgegeben Richtung angelegt und der Stapel dann während das elektrische Feld noch einwirkt, auf eine Temperatur unterhalb des Curie-Punkts abgekühlt, so kann eine Polarisierung des Stapels erreicht werden. Bei dieser Polarisierung nimmt das Volumen des piezo-elektrischen Kristalls zu, wobei gleichzeitig eine große interne Spannung erzeugt wird. Wenn nun also die Polarisation zu der Zeit vorgenommen wird, zu der der Kristall abkühlt, heben sich die Volumenzunahme aufgrund der Polarisierung und die Volumenabnahme aufgrund der Abkühlung auf, wobei gleichzeitig interne Spannungen abgebaut werden. Dieses Verfahren führt daher zu einem piezo-elektrischen Stapel, der verbesserte Dehnungseigenschaften aufweist.

Die US 5 758 397 A offenbart ein Verfahren zum Herstellen eines keramischen, piezoelektrischen Rosen-Transformators. Hierbei wird ein Primär- und Sekundärabschnitt des Transformators bei einer hohen Temperatur, bevorzugt unter Heißluft, einer ersten Polarisierung unterzogen, wohingegen der Sekundärabschnitt einer zweiten Polarisierung bei einer niedrigeren Temperatur, bevorzugt in Silikonöl unterzogen wird.

Weiterhin ist bekannt, dass eine Polarisierung dadurch erreicht werden kann, dass oberhalb des Curie-Punkts, d. h. oberhalb der Übergangstemperatur von der kubischen in die tetragonale bzw. rhomboedrische Phase ein elektrisches Feld angelegt wird. Dabei geht die Koerzitiv-Feldstärke im Bereich der Curie-Temperatur gegen Null und die Domänenwände sind entsprechend sehr beweglich. Zur Polarisation genügt daher bereits eine Feldstärke von 1 kV/mm, statt der sonst erforderlichen 2,5 kV/mm. Durch die erhöhte Beweglichkeit ist aufgrund des ferroelastischen Effekts eine relativ leichte Deformierbarkeit der Keramik möglich. Dadurch werden die Zugspannungen in dem inaktiven Bereich ausgeglichen und Rissbildungen vermieden.

Um einen eventuellen Ausschuss des Bauteils möglichst frühzeitig erkennen zu können ist es erforderlich, den Stapel möglichst früh in der Prozesskette zu charakterisieren.

Aufgabe der vorliegenden Erfindung ist es daher, die bekannten Verfahren zum Polarisieren so weiterzubilden, dass eine verbesserte Polarisierung erreicht wird, wobei gleichzeitig die Möglichkeit besteht, den Stapel frühzeitig in der Prozesskette zu charakterisieren.

Erfindungsgemäß wird diese Aufgabe durch die Merkmale des Anspruchs 1 gelöst.

Eine erste Polarisation erfolgt bei hoher Temperatur, die eine rissfreie Polarisation des Stapels gewährleistet. Dabei ist es nicht notwendig, den Stapel mechanisch vorzuspannen, etwa durch den Einbau in eine Rohrfeder. Anschließend kann der Stapel vollständig charakterisiert werden. Bevorzug wird dies in einer geeigneten Vorrichtung durchgeführt, in der eine mechanische Vorspannung erzeugt werden kann. Damit kann auch eine Bestimmung des Verhaltens des Bauteils bei hohen Feldstärken sowie des Ansteuerverhaltens erfasst werden. Durch eine zweite Polarisation im eingebauten Zustand kann der Polungszustand wie gewünscht eingestellt werden. Damit ist es möglich, im weiteren Betrieb eine Änderung der Länge oder anderer Eigenschaften des Stapels zu verhindern.

Mit dem erfindungsgemäßen Verfahren wird der Vorteil erreicht, dass der Stapel in einem sehr frühen Stadium der Prozesskette vollständig charakterisiert werden kann. Zu diesem Zeitpunkt sind noch keine weiterführenden Prozessschritte, wie etwa die Kontaktierung, die Passivierung, der Einbau oder ähnliches erfolgt. Somit wird auch der Nachteil überwunden, dass, entsprechend den bisher bekannten Verfahren, der Stapel erst nach dem vollständigen Einbau vermessen werden kann. Ausfälle, die durch ungenügende piezo-elektrische Aktivität oder anderer in der Keramik versteckt vorliegender Fehler, die nach üblichen Verfahren erst nach dem Einbau festgestellt werden können, führen zu einem großen Verlust an Wertschöpfung und können mit dem erfindungsgemäßen Verfahren vermieden werden.

Weiterbildungen und vorteilhafte Ausführungsformen der Erfindung sind Gegenstand der nachfolgenden Figuren sowie deren Beschreibungsteile. Es zeigen im Einzelnen:
- Fig. 1:: schematisch den Aufbau eines piezo-elektrischen Bauelements
- Fig. 2:: einen Verfahrensablauf schematisch dargestellt.

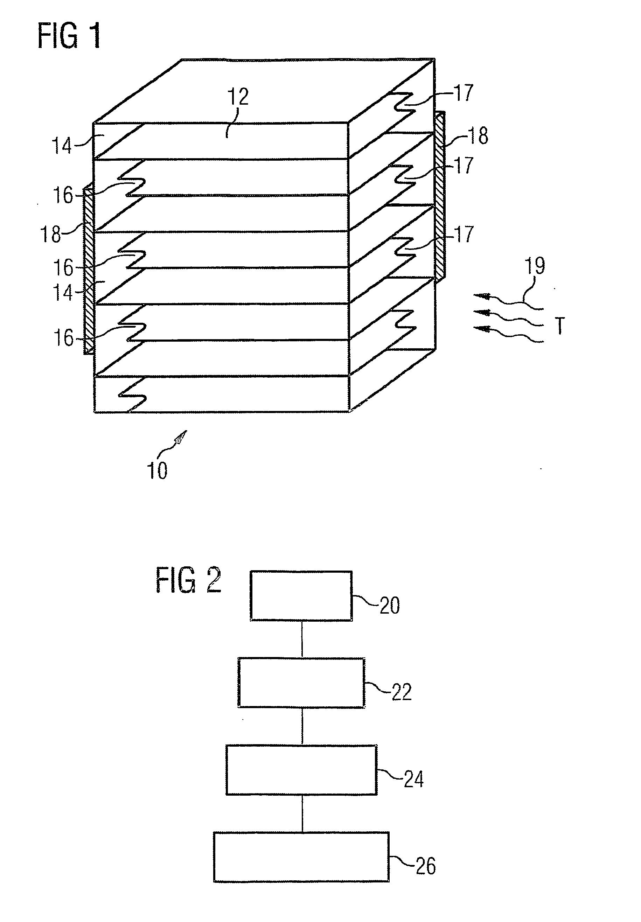

In Fig. 1 ist ein piezo-elektrisches Bauteil dargestellt, das als monolithischer Vielschicht-Piezoaktor 10 ausgebildet ist. Der Piezoaktor 10 weist eine Mehrzahl von Piezokeramikschichten 14 auf, die durch dazwischenliegende Metallelektroden 12 getrennt sind. Die Metallelektroden 12 weisen jeweils eine Aussparung 16, 17 auf, wobei die Aussparungen 16, 17 benachbarter Elektroden 12 jeweils an den gegenüberliegenden Kanten der Elektroden 12 vorgesehen sind. Damit können jeweils die übernächsten Nachbarn der Elektroden 12 über Verbindungsleiterbahnen 18 verbunden werden. Mit Hilfe der Verbindungsleiterbahnen 18 ist es möglich, an den Piezoaktor 10 ein elektrisches Feld anzulegen, das zum einen zum Polarisieren des Piezoaktors 10 und zum anderen zum späteren Betrieb dienen kann.

Nun wird eine erste Polarisation des Piezoaktors 10 durchgeführt, wobei hierzu der Piezoaktor 10 einer hohen Temperatur T ausgesetzt wird. Bevorzugt liegt diese Temperatur über dem Curie-Punkt der verwendeten Keramik. Zum Erreichen dieser Temperatur wird der Piezoaktor 10 vorteilhafterweise einer Wärmestrahlung 19, insbesondere heißer Luft, ausgesetzt. Alternativ kann er auch mit einem anderen Polarisationsmedium, wie etwa Öl oder Schutzgas erwärmt werden. Sobald der Piezoaktor 10 die gewünschte hohe Temperatur erreicht hat, wird mit dem Polarisieren des Piezoaktors begonnen. Da die Koerzitiv-Feldstärke bei der Curie-Temperatur gegen Null geht und die Domänenwände sehr beweglich sind genügt für die Polarisation eine relativ geringe Feldstärke von etwa 1 kV/mm. Nach dem ersten Polarisieren wird der Piezoaktor 10 abgekühlt. Anschließend kann bereits eine Charakterisierung der wesentlichen Eigenschaften oder eine vollständige Charakterisierung des Piezoaktors 10 vorgenommen werden. Hierzu wird der Piezoaktor 10 in eine geeignete Vorrichtung eingebaut. In dieser Vorrichtung kann dann z. B. eine mechanische Vorspannung aufgebracht werden und die Bestimmung des Verhaltens und damit die Bestimmung der leistungsbestimmenden Merkmale des Piezoaktors 10 vorgenommen werden. Insbesondere kann das Verhalten bei hohen Feldstärken und Ansteuerleistungen erfasst werden. Sobald das Verhalten des Piezoaktors 10 bestimmt ist, kann eine zweite Polarisation im eingebauten Zustand des Piezoaktors 10 vorgenommen werden. Damit lässt sich der Polungszustand des Piezoaktors 10 so einstellen, dass im Betrieb des Piezoaktors 10 keine weitere Änderung der Länge oder einer anderen Größe erfolgt.

Damit ist es also möglich, den Stapel in einem sehr frühen Stadium der Prozesskette vollständig zu charakterisieren. Ausfälle durch ungenügende piezo-elektrische Aktivität oder andere Fehler in der Keramik können entsprechend bereits zu einem sehr frühen Zeitpunkt erkannt werden. Damit werden lediglich diejenigen Piezoaktoren 10 weiterführenden Prozessen, wie etwa dem Kontaktieren, Passivieren oder Einbau, zugeführt, die bei der Charakterisierung als geeignet einklassifiziert worden sind.

Fig. 2 zeigt schematisch den erfindungsgemäßen Verfahrensablauf. Im Schritt 20 wird zunächst eine erste Polarisation des Piezoaktors 10 (Fig. 1) bei hoher Temperatur, insbesondere bei einer ersten Temperatur über dem Curie-Punkt der Keramik vorgenommen. Dies erlaubt eine rissfreie Polarisation des Stapels ohne die Notwendigkeit ihn mechanisch vorzuspannen. So kann insbesondere darauf verzichtet werden, den Stapel für die erste Polarisierung in eine Rohrfeder einzubauen.

Im Schritt 22 wird der bei hoher Temperatur polarisierte Stapel im Hinblick auf seine Eigenschaften insbesondere vollständig charakterisiert oder in eine Gruppe klassifiziert. Dies erfolgt in einer geeigneten Vorrichtung, in der z. B. eine mechanische Vorspannung aufgebaut werden kann. Damit kann das Verhalten des Piezoaktors auch bei hohen Feldstärken und Ansteuerlasten erfasst werden.

Im Schritt 24 werden diejenigen Piezoaktoren 10, die für die spätere Verwendung aufgrund der Charakterisierung geeignet sind, in das Aktorgehäuse eingebaut, so dass bereits zu diesem Zeitpunkt bekannt ist, dass das verwendete Bauteil die erwartete Leistung im Rahmen der Spezifikation erfüllt.

Im Schritt 26 erfolgt eine zweite Polarisation des Piezoaktors 10 im eingebauten Zustand, d.h. im Aktorgehäuse, in der Piezoaktor 10 durch eine Feder vorgespannt ist. Damit wird der Polungszustand so eingestellt, dass im weiteren Betrieb keine Veränderung der Länge oder anderer Eigenschaften mehr eintritt. Diese Polarisation findet bei einer niedrigen zweiten Temperatur, vorzugsweise unterhalb der Curie-Temperatur statt.

Mit dem Verfahren ist es nun möglich, zu einem sehr frühen Zeitpunkt in der Prozesskette zu entscheiden, welche Piezoaktoren für die spätere Verwendung Charakteristiken aufweisen, die für die beabsichtigte Verwendung noch in der erforderlichen Toleranz liegen. Dies führt zu einer großen Steigerung der Wertschöpfung, da auf unnötige weitere Prozessschritte an ungeeigneten Piezoaktoren verzichtet werden kann.

Eine für die elektrisch-mechanische Wandlung eines piezoelektrischen Elements typische Kennzahl ist die d33-Kennzahl. Unter der Charakterisierung einer Piezokeramik versteht man somit das Messen der elektromechanischen Kopplungsgrößen, insbesondere der d33: Mechanische Dehnung S=d*E (E=elektrisches Feld). Daneben werden noch andere Größen wie die elektrische Kapazität bestimmt. Diese Größen sind von dem Polungszustand, d.h. der Ausrichtung der dielektrischen Domänen abhängig und sind daher geeignet, diesen zu Charakterisieren. Der Polungszustand hängt wiederum vom Material, der Mikrostruktur (Korngröße, Poren) und der Polung selbst ab.

Erst nach einer Ausrichtung der Domänen (sprich Polung oder Polarisierung) lassen sich Aussagen zu diesen Werten geben.

Somit ist beispielsweise durch Anlegen einer vorgegebenen elektrischen Spannung am piezoelektrischen Element eine mechanische Auslenkung messbar.

Im Rahmen der Injektorentwicklung wird meistens U40 und Q40 angegeben. Das ist die Spannung bzw. Ladung die notwendig ist, um eine Auslenkung von 40 µm zu erreichen. Die Aussage ist die gleiche wie die des d33.

Durch das erste, zumindest teilweise durchgeführte Polarisieren ist das piezoelektrischen Element bereits vermessbar, so dass durch das "Charakterisieren" eine Qualitätskontrolle durchführbar ist und ein außerhalb der zulässigen Toleranz liegendes piezoelektrischen Element schon frühzeitig im Fertigungsprozess erkannt und aussortiert wird.

## Patentansprüche

1. Verfahren zur Herstellung eines piezo-elektrischen Bauteils, insbesondere eines Piezoaktors (10) mit einer Vielzahl von Piezokeramikschichten (14) und dazwischen liegenden Metallelektroden (12), wobei das piezo-elektrische Bauteil insbesondere durch Anlegen eines elektrischen Polarisationsfeldes polarisierbar ist, wobei das piezo-elektrische Bauteil bei einer ersten hohen Temperatur polarisiert, dann abgekühlt und charakterisiert und bei einer zweiten Temperatur, die niedriger ist als die erste, ein zweites Mal polarisiert wird, und die zweite Polarisierung unter mechanischer Vorspannung erfolgt.

2. Verfahren nach Anspruch 1, **dadurch gekennzeichnet, dass** das piezo-elektrische Bauteil bei der ersten Temperatur im Wesentlichen mechanisch vorspannungsfrei polarisiert wird.

3. Verfahren nach Anspruch 1 oder 2, **dadurch gekennzeichnet, dass** das piezo-elektrische Bauteil zum Charakterisieren in einer geeigneten mechanischen Vorrichtung, insbesondere in einer Vorspanneinrichtung vorgespannt wird.

4. Verfahren nach einem der vorherigen Ansprüche, **dadurch gekennzeichnet, dass** die Charakterisierung des piezoelektrischen Bauteils bei hohen Feldstärken erfolgt.

5. Verfahren nach einem der vorherigen Ansprüche, **dadurch gekennzeichnet, dass** das piezoelektrische Bauteil bei der zweiten Polarisierung in ein Piezo-Aktorgehäuse eingebaut, vorzugsweise eingeschweißt, ist.

6. Verfahren nach einem der vorherigen Ansprüche, **dadurch gekennzeichnet, dass** die erste Temperatur größer ist als die Curie-Temperatur des Keramikmaterials, insbesondere 20 bis 70 °C über der Curie-Temperatur liegt.

7. Verfahren nach einem der vorherigen Ansprüche, **dadurch gekennzeichnet, dass** die zweite Temperatur unterhalb des Curie-Punkts liegt.

8. Verfahren nach einem der vorherigen Ansprüche, **dadurch gekennzeichnet, dass** zum ersten Polarisieren eine Feldstärke verwendet wird, die unterhalb der Feldstärke des zweiten Polarisierens liegt.

9. Verfahren nach einem der vorherigen Ansprüche, **dadurch gekennzeichnet, dass** zum ersten Polarisieren eine Feldstärke von etwa 1 kV/mm verwendet wird, bei der vorzugsweise wenig Risse im piezoelektrischem Bauteil entstehen.

10. Verfahren nach einem der vorherigen Ansprüche, **dadurch gekennzeichnet, dass** zum ersten Polarisieren eine Feldstärke von etwa 2 kV/mm verwendet wird.

11. Verfahren nach einem der vorherigen Ansprüche, **dadurch gekennzeichnet, dass** unter der Charakterisierung einer Piezokeramik das Messen der elektromechanischen Kopplungsgrößen verstanden wird;
vorzugsweise ist dabei das piezoelektrische Element zumindest soweit polarisiert, dass seine elektrischen/mechanischen Eigenschaften vermessbar sind, und dass vorzugsweise durch Anlegen einer vorgegebenen elektrischen Spannung bzw. durch Übertragen einer vorgegebenen Ladungsmenge auf das piezoelektrische Element eine mechanische Auslenkung messbar ist, und/oder vorzugsweise durch eine vorgegebene mechanische Einwirkung auf das piezoelektrische Element eine elektrische Ladungsbewegung messbar ist.

12. Verfahren nach einem der vorherigen Ansprüche, **dadurch gekennzeichnet, dass** durch das Charakterisieren eine Qualitätskontrolle durchführbar ist, so dass eine außerhalb einer vorgegebenen Toleranz liegende, typische Kennzahl eines piezoelektrischen Elements erkannt wird und das piezoelektrische Bauteil vorzugsweise aussortiert wird.

13. Injektor mit einem piezo-elektrischen Bauteil, **dadurch gekennzeichnet, dass** das piezo-elektrische Bauteil mit den Merkmalen eines der vorherigen Ansprüche hergestellt ist.

## Claims

1. Method for producing a piezoelectric component, especially a piezoactuator (10) with a plurality of piezoceramic layers (14) and metal electrodes (12) lying between them, with the piezoelectric component especially able to be polarised by application of an electrical polarisation field, with the piezoelectric component being polarised at a first high temperature, then cooled and **characterised**, and polarised a second time at a second temperature which is lower than the first, and with the second polarisation being undertaken under mechanical prestressing.

2. Method according to claim 1, **characterised in that** the piezoelectric component is polarised at the first temperature essentially without any mechanical prestressing.

3. Method according to claim 1 or 2, **characterised in that** the piezoelectric component is prestressed for **characterising in** a suitable mechanical device, especially in a prestressing device.

4. Method according to one of the previous claims, **characterised in that** the piezoelectric component is **characterised** at high field strengths.

5. Method according to one of the previous claims, **characterised in that** the piezoelectric component is installed, preferably welded, into a piezoactuator housing during the second polarisation.

6. Method according to one of the previous claims, **characterised in that** the first temperature is greater than the Curie temperature of the ceramic material, especially lies 20 to 70 °C above the Curie temperature.

7. Method according to one of the previous claims, **characterised in that** the second temperature lies below the Curie point.

8. Method according to one of the previous claims, **characterised in that** a field strength is used for the first polarisation which lies below the field strength of the second polarisation.

9. Method according to one of the previous claims, **characterised in that** a field strength of around 1 kV/mm is used for the first polarisation, at which preferably few cracks occur in the piezoelectric component.

10. Method according to one of the previous claims, **characterised in that** a field strength of around 2 kV/mm is used for the first polarisation.

11. Method according to one of the previous claims, **characterised in that** characterisation of a piezoceramic is taken to mean measuring the electromechanical coupling variables;
preferably in this case the piezoelectric element is at least polarised to the extent that its electrical/mechanical characteristics are able to be calibrated, and that preferably by application of a predetermined electrical voltage or by transmission of a predetermined quantity of charge to the piezoelectric element a mechanical deflection is able to be measured and/or an electrical charge movement is preferably able to be measured by a predetermined mechanical effect on the piezoelectric element.

12. Method according to one of the previous claims, **characterised in that** the characterisation allows a quality control to be performed, so that a typical characteristic value of a piezoelectric element lying outside a predetermined tolerance is detected and the piezoelectric component is preferably screened out.

13. Injector with a piezoelectric component, **characterised in that** the piezoelectric component is produced using the features of one of the previous claims.

## Revendications

1. Procédé de fabrication d'un composant piézo-électrique, en particulier d'un actionneur pièzo-électrique (10) comprenant une pluralité de couches piézo-céramiques (14) et d'électrodes métalliques (12) interposées entre elles, le composant piézo-électrique pouvant en particulier être polarisé par application d'un champ de polarisation électrique, le composant piézo-électrique étant polarisé à une première température élevée puis refroidi et **caractérisé**, puis polarisé une deuxième fois à une deuxième température qui est inférieure à la première, et la deuxième polarisation s'effectuant sous précontrainte mécanique.

2. Procédé selon la revendication 1, **caractérisé en ce que** le composant piézo-électrique est polarisé à la première température sensiblement sans précontrainte mécanique.

3. Procédé selon la revendication 1 ou 2, **caractérisé en ce que**, pour la caractérisation, le composant piézo-électrique est précontraint dans un dispositif approprié, en particulier dans un dispositif de précontrainte.

4. Procédé selon une des revendications précédentes, **caractérisé en ce que** la caractérisation du composant piézo-électrique s'effectue en présence de grandes intensités de champ.

5. Procédé selon une des revendications précédentes, **caractérisé en ce que**, lors de la deuxième polarisation, le composant piézo-électrique est monté, de préférence soudé, dans un boîtier d'actionneur piézo-électrique.

6. Procédé selon une des revendications précédentes, **caractérisé en ce que** la première température est supérieure à la température de Curie de la matière céramique et est en particulier supérieure de 20 à 70°C à la température de Curie.

7. Procédé selon une des revendications précédentes, **caractérisé en ce que** la deuxième température est inférieure au point de Curie.

8. Procédé selon une des revendications précédentes, **caractérisé en ce que**, pour la première polarisation, on utilise une intensité de champ qui est inférieure à l'intensité de champ de la deuxième polarisation.

9. Procédé selon une des revendications précédentes, **caractérisé en ce que**, pour la première polarisation on utilise une intensité de champ d'environ 1kV/mm, à laquelle il ne se forme de préférence que peu de fissures dans le composant piézo-électrique.

10. Procédé selon une des revendications précédentes, **caractérisé en ce que**, pour la première polarisation, on utilise une intensité de champ d'environ 2kV/mm.

11. Procédé selon une des revendications précédentes, **caractérisé en ce qu'**on entend par caractérisation d'une piézo-céramique la mesure des grandeurs de couplage électromécanique ;
l'élément piézo-électrique est de préférence polarisé au moins suffisamment pour que ses propriétés électromécaniques soient mesurables et pour qu'on puisse mesurer, de préférence une excursion mécanique par application d'une tension électrique prédéterminée, ou par application d'une quantité de charge prédéterminée à l'élément piézo-électrique, et/ou que, de préférence on puisse mesurer un déplacement de la charge électrique par l'application d'une influence mécanique prédéterminée à l'élément piézo-électrique,

12. Procédé selon une des revendication précédentes, **caractérisé en ce que** par la caractérisation, on peut exécuter un contrôle de qualité, de sorte qu'on détecte un indice typique d'un élément piézo-électrique qui se trouve en dehors d'une tolérance prédéterminée, et que le composant piézo-électrique est de préférence refusé.

13. Injecteur équipé d'un composant piézo-électrique, **caractérisé en ce que** le composant piézo-électrique est fabriqué avec les caractéristiques d'une des revendications précédentes.
